(19) **Europäisches Patentamt**

**European Patent Office**

**Office européen des brevets**

(11) **EP 1 715 356 A1**

(12) **EUROPEAN PATENT APPLICATION**

(43) Date of publication:
25.10.2006 Bulletin 2006/43

(51) Int Cl.:
*G01R 33/06* (2006.01) *H01L 29/66* (2006.01)

(21) Application number: 05447084.4

(22) Date of filing: 21.04.2005

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(71) Applicant: **INTERUNIVERSITAIR
MICROELEKTRONICA CENTRUM ( IMEC)
3001 Leuven (BE)**

(72) Inventor: **Van Roy, Wim
1640 St. -Genesius-Rode (BE)**

(74) Representative: **Van Malderen, Joëlle et al
pronovem - Office Van Malderen
Avenue Josse Goffin 158
1082 Bruxelles (BE)**

(54) **Spin detection device and methods for use thereof**

(57) The present invention is related to methods for and devices for electrical spin detection. A method for spin detection of charged carriers having a spin and forming a flux in a medium is disclosed, comprising measuring a first current on a first contact on said medium that has a first spin selectivity, measuring a second current on a second contact on said medium that has a second spin selectivity, comparing said first current and said second current, and deriving the average or statistically relevant spin state of said flux of charge carriers. Corresponding devices are disclosed.

Other embodiments of the present invention disclose a method for spin detection of charged carriers having a spin and forming a flux in a medium, said flux having active and inactive periods comprising determining a starting time and place, determined as the last moment in time at which said spin of said charge carriers is statistically controlled for an active period, measuring a current in a first contact on said medium that has a certain spin selectivity over a certain period in time, and deriving the average or statistically relevant spin state of said period of flux of charge carriers.

Area in which the spin of the charge
carriers is statistically controlled

Collection contact 1

Flux of charge carriers

Transport medium

Fig. 1

## Description

## Field of the invention

The present invention is related to methods and devices for electrical spin detection.

## State of the art

Traditional semiconductor transistors operate through the movement of electrical charge carriers (electrons or holes) in the device. For a long time it has been ignored that these carriers also possess a property called "spin". Recently a number of spin transistors and other spintronics devices have been proposed [Zutic, Fabian, and Das Sarma, Rev. Modern Physics 76, 323-410 (2004)] that make use of the spin properties or of spin-polarized transport inside the semiconductor.

In general the operation of such a spintronics device can comprise a combination of the following operations:

- create or inject spin-polarized carriers in the semiconductor
- transport the spin-polarized carriers
- manipulate the spin-polarized carriers
- store the spin information
- retrieve the spin information
- detect the polarization of the spin-polarized carriers in the semiconductor, or extract the spin-polarized carriers from the semiconductor.

In order to be able to build circuits consisting of many of these spintronics devices, these operations should be performed in a way that allows large-scale integration. As an example, injection and detection of spin-polarized carriers using an electrical contact leads to much easier integration than optical injection and detection using circularly polarized light. In addition electrical injection and detection are not limited to a subset of semiconductors as is the case for optical injection and detection.

Several of these steps have already been successfully demonstrated, and electrical spin injection is now well established. Electrical spin detection appears to be the reverse operation from injection, and one would have expected that experimental demonstrations would have followed soon after the demonstration of electrical spin injection. However, no large effects have been demonstrated so far: the signals were either unclear, limited to spikes in a very small bias range, or much smaller than expected.

Some use a single spin-selective contact that allows a current of charge carriers to flow into the contact. Various methods have been used to create a flux of charge carriers with a certain spin-polarization. Some use a beam of circularly polarized light to generate spin-polarized electrons in a GaAs/AlGaAs transport structure, while many proposed spin transistor concepts use an electrical contact to inject spin-polarized carriers into semiconductors such as Si or GaAs.

The common factor between all these experiments is that the amplitude of the current I of charge carriers flowing into the contact is proportional to the number of charge carriers $n\uparrow + n\downarrow$ (the notations "$\uparrow$" and "$\downarrow$" down refer to spin-up and spin down states respectively) that are presented to the contact, and with different proportionality factors $c\uparrow$ and $c\downarrow$ for both types of spin: $I = c\uparrow * n\uparrow + c\downarrow * n\downarrow$. The aim of the electrical spin detection contact is then to obtain different currents when the spin-polarization of the incoming flux is changed. One common way of performing the measurement consists of varying the spin-polarization of the incoming flux without changing the total number of carriers, and looking for a change in current into the contact. Another common way is to leave the spin polarization of the incoming flux constant, but to change the proportionality factors of the detector contact. This can e.g. be realized by reversing the magnetization direction of a magnetic contact.

This type of devices has shown some spin selectivity, but much less than expected. A problem discovered by the inventors is that the carriers that are initially rejected by a certain contact will be accepted sometime later, after their spin has been flipped. Let's take an example with a perfectly selective contact that accepts only spin up carriers, i.e. $c\downarrow = 0$. If a spin down electron arrives, it will not be accepted and thus accumulate underneath the contact. After a random time the spin of the carrier will be disturbed, and may flip from spin-down to spin-up. This is a random process where the rate of disturbance is given in terms of a spin-relaxation time.

All the prior art measurements are steady-state measurements, i.e. measurements that are slow compared to the spin-flip time of the carriers in the medium under study. As spin-down carriers keep coming in and are rejected by the contact, more and more of them accumulate underneath the contact. Some of these carriers will see their spin flipped to spin-up, and will be accepted by the contact. At a certain moment (this is after several times the spin-flip time) the number of accumulated spin-down carriers will become so large that the number of carriers that flips from spin-down to spin-up becomes equal to the number of incoming spin-down carriers. When this happens the number of accumulated carriers does not change any longer (this is the so-called steady state condition). The number of carriers that experience a spin-flip event and are accepted by the contact is now equal to the flux of incoming spin-down carriers. In other words, the current into the contact is now identical to the current that would flow if all the incoming carriers had had the right spin to start with.

In other words, in the presence of spin-flip scattering in the medium, a single spin-selective contact loses its spin-selectivity if the time-frame of the experiment is much slower than the characteristic spin-flip time in the medium.

Others consider a device with electrical injection and detection contacts that operate under very low bias conditions. When rejected carriers start to accumulate and their density increases, their Fermi-level $E_f$ increases. If this increase $\Delta E_f$ is larger than the applied bias V ($|\Delta E_f| > |qV|$ where q = $1.602 \times 10^{-19}$ C is the elementary charge), this will suppress the further injection of "wrong" carriers, and thus lower the current compared to the situation where carriers with the "right" spin are injected. The bias regime where this feed back mechanism functions is called "linear regime". Under these conditions the device does discriminate between both types of spins. However since this bias range is very small (not substantially larger than 10 mV), these operating conditions are of limited practical use.

Others use two contacts with a different sensitivity in such a way that they do not accept any current but measure the Fermi-levels of both spin types (or equivalently the Fermi-level of one type of spin together with an average of the two types of spins - the same information can be gained from both configurations). Again this know-how is limited to operating conditions that are of limited practical use, with small signal levels (not substantially larger than 10 mV), and with little drive capability, i.e., where the output can not be used as an input for a second device.

**Summary of the invention**

The present invention concerns a method for spin detection of charged carriers having a spin and forming a flux in a transport medium, comprising the steps of:

- Providing a flow of charged charge carriers from a starting point at a specific starting time to a first collection contact through said transport medium, wherein said charge carriers travel from said starting point to said first collection contact in a first travel time period,
- measuring a first current of charge carriers during a measuring time period in said first collection contact in electrical contact with said transport medium, said first collection contact having a first spin selectivity,
- deriving the spin state of said flux of charge carriers during said period, and
- removing the charge carriers having a spin state for which said first collection contact is not selective.

In a specific embodiment, the sum of the measuring time period and the first travel time period is smaller than the average spin flip time and the step of removing the charge carriers comprises providing a waiting time in which no flux is present in the transport medium, wherein said waiting time is higher than the average spin flip time. The method can further comprise the step of determining a current integral over time of the current of charge carriers in the first collection contact over the measuring time period.

In an alternative specific embodiment, the step of removing the charge carriers can comprise the step of measuring a second current in a second collection contact in electrical contact with said transport medium, said second collection contact having a second spin selectivity different from said first spin selectivity, wherein said charge carriers travel from said starting point to said second collection contact in a second travel time period. The method can further comprise the step of comparing said first current and said second current. The measuring step can be started when the spin of said flux of charge carriers is in a steady state. The method according this embodiment can further comprise the steps of:

- determining a first current integral in time for the first current over a first time period,
- determining a second current integral in time for the second current over a second time period,
- comparing said first current integral and said second current integral.

The first time period and the second time period preferably start respectively after the sum of starting time, first travel time and the sum of starting time and second travel time. The duration of the first time period and second time period are preferably respectively smaller than the average spin flip time minus the first travel time and smaller than the average spin flip time minus the second travel time.

In another aspect, the present invention concerns a device for performing spin detection, comprising:

● a transport medium, allowing for transport of charge carriers having a spin;

● a charge carrier source for providing a flux of charge carriers into said transport medium

● means for statistically controlling said spin of said charge carriers at a predetermined moment in time;

● a first collection contact in electrical contact with said transport medium, said first collection contact having a first spin-selectivity;

● a first current measuring device arranged to measure the current in said first collection contact;

● a second collection contact in electrical contact with said transport medium, said second collection contact having a second spin-selectivity;

● a second current measuring device arranged to measure the current in said second collection contact;

wherein said first selectivity is different from said second selectivity and whereby said flux of charge carriers is guided towards said first and said second collection contacts from said predetermined moment in time. The first collection contact or second collection contact is preferably selected from the group consisting of a magnetic metal; a ferromagnetic metal; a ferrimagnetic metal; a tunnel injector selected from the group consisting of a magnetic metal with a tunnel barrier, a non-magnetic metal with a magnetic tunnel barrier, a magnetic metal with a magnetic tunnel barrier, a ferromagnetic metal with a tunnel barrier, a non-ferromagnetic metal with a magnetic tunnel barrier, a ferromagnetic metal with a magnetic tunnel barrier, a ferrimagnetic metal with a tunnel barrier, a non-ferrimagnetic metal with a magnetic tunnel barrier, a ferrimagnetic metal with a magnetic tunnel barrier; a half-metallic ferromagnet, a half-metallic ferrimagnet, a half-metallic antiferromagnet, a magnetic semiconductor, or a ferromagnetic semiconductor. The charge carrier source preferably comprises an electrical injection contact. Advantageously, the injection contact has a predetermined magnetic polarisation and the injection contact functions as said means for statistically controlling said spin of said charge carriers. The means for statistically controlling the spin of the charge carriers is preferably a electromagnetic field, localised at a specific position along the path of the charge carriers in the transport medium, an optical injection means, the result of a spintronic action, manipulation, operation, filter or calculation, or the result of a quantum computing or quantum cryptography operation.

In the device according to the present invention, the charge carrier source is preferably arranged to provide a potential difference between said injection contact and said first and said second collection contacts. Preferably, the first collection contact and said second collection contact have a different spin polarisation. The first collection contact and the second collection contact preferably have different magnetization directions, forming an angle different from 0 or having a different amplitude or magnitude.

The injection contact and the first and the second collection contact can be positioned on the same side or on different sides of said transport medium.

Preferably, in the device of the present invention, the transport medium comprises a semiconductor material or a metal.

The present invention also concerns a device for performing spin detection, comprising:

● a transport medium, allowing for transport of charge carriers having a spin;

● means for providing a flux of charge carriers into said medium;

● means for statistically controlling said spin of said charge carriers at a predetermined moment in time;

● a first collection contact

● a means for measuring the current in said first collection contact.

Said device can be characterised in that all elements or components present in the detector or detector chain are ultrafast elements.

Another aspect of the present invention is a method for information transfer, comprising the steps of;

- Providing information to transfer,
- encoding said information into a bit stream with an encoder,
- mapping said bit stream onto a block signal having a constant block frequency, said block signal being a periodical flux of charged carriers having a spin, wherein the average spin state of said active period is correlated with the bit content,
- Providing a transport means for said block signal.
- Applying any of the methods according to the present invention for measuring said spin for each of said active periods of said block signal, and
- Decoding the spin information into a bitstream

Embodiments of the present invention provide for methods and devices for electrical spin detection, which alleviates or avoids the problems of the prior art.

The present invention comprises methods and devices that lead to an improved electrical spin detection. Embodiments of the invention can be used in any device that combines electrical spin detection with other operations such as those listed below or others;

- create or inject spin-polarized carriers in the semiconductor
- transport the spin-polarized carriers
- manipulate the spin-polarized carriers
- store the spin information
- retrieve the spin information
- detect the polarization of the spin-polarized carriers in the semiconductor, or extract the spin-polarized carriers from the semiconductor

The time after which the spin of an individual particle is disturbed varies stochastically. When considering an ensemble of particles the average rate at which spins are disturbed is characterized by the spin relaxation time. More exactly, the spin relaxation time is the time after which the spin of 63.21% of the particles has been disturbed (where 63.21% = (1-1/e) with e the base of the natural logarithm). This spin relaxation time is also the parameter which characterizes the speed with which a non-equilibrium ensemble of particles evolves towards the equilibrium state.

In the description the following terms are used and are known in the art, but an additional definition is given below;

- the magnetisation M (of for instance a collection con-

tact):

$$M \propto \frac{n\uparrow + n\downarrow}{volume}$$

- the polarisation P (of for instance a collection contact)

$$P = \frac{n(E_f)\uparrow - n(E_f)\downarrow}{n(E_f)\uparrow + n(E_f)\downarrow}$$

It can be remarked that M/P = constant. "Volume" is the physical volume of the element (for instance a collection contact). $E_f$ is the Fermi Energy.

The current polarization is similarly $P_I = (I\uparrow - I\downarrow)/(I\uparrow + I\downarrow)$ where $I\uparrow$ and $I\downarrow$ are the currents carried by carriers with spin up and spin down, resp. Depending on how the transport mechanism exactly works, the currents $I\uparrow$ and $I\downarrow$ can be proportional with $n\uparrow$ and $n\downarrow$ or with the densities weighed with the Fermi velocity $v_F$ to a certain power i: $n\uparrow v_F{}^\wedge i$ and $n\downarrow v_F{}^\wedge i$, where the exponent i can be 1 or 2 or other values.

A device for performing spin detection is described, comprising :

a. a transport medium, allowing for transport of charge carriers having a spin;
b. means for providing a flux of charge carriers into said medium
c. means for statistically controlling said spin of said charge carriers at a predetermined moment in time; (with "statistically controlling" is meant that the distribution of states of the charge carriers is known with a reasonable degree of certainty (for instance more than 10%, 20%, 30%, 40%, 50%, 60%, 70%, 80%, 90%, 95%, 99%). As a limit case the states of the charge carriers is known with 100% certainty.)
d. a first collection contact; --- this can be for instance a magnetic metal, a ferromagnetic metal, a ferrimagnetic metal, a tunnel injector [(i) a magnetic metal with a tunnel barrier (ii) a non-magnetic metal with a magnetic tunnel barrier (iii) a magnetic metal with a magnetic tunnel barrier, (ib) a ferromagnetic metal with a tunnel barrier (iib) a non-ferromagnetic metal with a magnetic tunnel barrier (iiib) a ferromagnetic metal with a magnetic tunnel barrier, (ic) a ferrimagnetic metal with a tunnel barrier (iic) a non-ferrimagnetic metal with a magnetic tunnel barrier (iiic) a ferrimagnetic metal with a magnetic tunnel barrier], a half-metallic ferromagnet, a half-metallic ferrimagnet, a half-metallic antiferromagnet, a magnetic semiconductor, a ferromagnetic semiconductor, - any of the above tunnel injectors with a magnetic or ferromagnetic semiconductor instead of the magnetic or ferromagnetic metal --- having a first spin-selectivity onto said transport medium; (the spin-selectivity can be defined as S = (I↑ - I↓)/(I↑ + I↓) and I↑ (I↓) is the current of charge carriers flowing from the semiconductor into the contact under given bias conditions and a given number of charge carriers that all have their spin up (down). S can thus depend on for instance bias-conditions.
e. a first means for measuring the current in said first collection contact. Such a current measuring means can be a an amperemeter, a transistor, a chip, a multimeter, or any other means which can measure current.
f. a second collection contact having a second spin-selectivity onto said transport medium; the same possibilities as the first collection contact can be used.
g. a second means for measuring the current in said second collection contact; cfr also first means for measuring current.

wherein said first selectivity is different from said second selectivity and whereby said flux of said charge carriers is guided towards said first and said second collection contacts from said predetermined moment in time.

Materials used may include:

- Ferromagnetic metals: Iron, Cobalt, Nickel and their alloys and compounds, transition metals and their alloys and compounds, rare earth metals and their alloys and compounds, magnetic oxides, magnetic semiconductors
- HMF (half-metallic ferromagnets): Heusler alloys (NiMnSb, PtMnSb, Co2MnSi, CoMnGe, ...), Fe3O4 (magnetite), Cr2O3, La1/3 Sr2/3 MnO3
- Ferromagnetic semiconductors: (Ga,Mn)As, (In,Mn)As, (Ga,Mn)N, SiMn, GeMn and the equivalent combinations with Cr, Ni, Fe, Co instead of Mn,
- II-VI Magnetic semiconductors,
- Chalcopyrites,
- Magnetic oxide semiconductors (e.g. ZnO:Co, TiO2: Co, HFO2)

In certain embodiments the means for providing the flux of said charge carriers can be an electrical injection contact.

In preferred embodiments the injection contact has a predetermined magnetic polarisation and the injection contact consequently functions as said means for statistically controlling said spin of said charge carriers.

The means for statistically controlling said spin of said charge carriers can be a electromagnetic field, localised at a certain position along the path of said charge carriers in said transport medium. It can also be an optical injection means, the result of a spintronic action / manipulation / operation / calculation, the result of a quantum computing or quantum cryptography operation, ...

In certain embodiment the means for providing a flux of charge carriers further comprises a potential difference between said injection contact and said first and said second collection contacts.

In certain embodiments according to the present invention the first collection contact and said second collection contact can have a different spin polarisation.

The first collection contact and said second collection contact have different magnetization directions, forming an angle different from 0, as for instance but not only 180 or 90 degrees.

The injection contact and said first and said second collection contact can be positioned on the same side or on different sides like for instance opposite sides of said transport medium.

The transport medium can comprise a semiconductor material or a metal as for instance; an illustrative but not extensive list is given next.

Metals can be selected from the group consisting of Lithium, Beryllium, Sodium, Magnesium, Aluminium, Potassium, Calcium, Titanium, Vanadium, Chromium, Manganese, Iron, Cobalt, Nickel, Copper, Zinc, Arsenic, Zirconium, Molybdenium, Silver, Gold, Cadmium, Antimony, Barium, Osmium, Platinum, Palladium, Mercury, Thallium, Lead, Uranium, and their alloys and compounds

Semiconductor materials can be selected from the group consisting of Group IV elemental semiconductors: Boron (B), Diamond (C),Silicon (Si),Germanium (Ge),Gray Tin (Sn), Phosphorus (P), Selenium (Se), Tellurium (Te); Group IV compound semiconductors: Silicon carbide (SiC), Silicon germanide (SiGe), Boron-Carbon (BC), Boron-Silicon (BSi), Boron-Phosphorus (BP),Silicon-Tin (SiSn), Germanium-Tin (GeSn); Group III-V semiconductors: Boron nitride (BN),Boron Phosphide (BP), Boron Arsenide (BAs), Aluminium antimonide (AlSb),Aluminium arsenide (AlAs), Aluminium nitride (AlN), Aluminium phosphide (AlP), Gallium antimonide (GaSb), Gallium arsenide (GaAs), Gallium nitride (GaN), Gallium phosphide (GaP), Indium antimonide (InSb), Indium arsenide (InAs), Indium nitride (InN), Indium phosphide (InP); Group III-V ternary, quaternary, ... semiconductor alloys: Aluminium gallium arsenide ($Al_xGa_{1-x}As$), and other combinations of the above III-V semiconductors; Group II-VI semiconductors: Cadmium selenide (CdSe), Cadmium sulfide (CdS), Cadmium telluride (CdTe), Zinc oxide (ZnO), Zinc selenide (ZnSe), Zinc sulfide (ZnS), Zinc telluride (ZnTe), Mercury selenide (HgSe), Mercury sulfide (HgS), Mercury telluride (HgTe); Group II-VI ternary, quaternary, ...semiconductor alloys: Cadmium mercury telluride ((Cd,Hg)Te), and other combinations of the above II-VI semiconductors; Group I-VII semiconductors: Cuprous chloride (CuCl); Group IV-VI semiconductors: Lead sulfide (PbS), Lead telluride (PbTe), Tin sulfide (SnS), Layered semiconductors, Lead iodide (PbI2), Molybdenum disulfide (MoS2), Gallium Selenide (GaSe), Miscellaneous oxides, Copper oxide (CuO), Cuprous oxide (Cu2O), Organic semiconductors, Magnetic semiconductors; Ternary Adamantine Semiconductors; Ternary Analogs of the III-V Adamantine Semiconductors; the II-IV-V2 Compounds (Ternary Pnictides); the I-IV2-V3 Compounds; Ternary Analogs of II-VI Adamantine Semiconductors; I-III-VI2 Compounds; I2-IV-VI3 Compounds; I3-V-VI4 Compounds; Defect Adamantine Semiconductors; IV3-V4 Compounds; III2-VI3 Compounds; Defect Ternary Compounds,III2-IV-VI Compounds; Non-Adamantine Semiconductors and Variable-Composition Semiconductor Phases, IA-IB Semiconductors, Semiconductors in the I-V Binary Systems, IA-VB Compounds, (IA)3-VB Compounds, I-VI Compounds, Copper and Silver Oxides, Copper and Silver Chalcogenides, II2-IV Compounds with Antifluoride Structure, IV-VI Galenite Type Compounds,V2-VI3 Compounds, Binary Compounds of the Group VIIIA Elements, Semiconductor Solid Solutions, Alloys of Elemental Semiconductors, III-V/III-V Semiconductor Alloys, II-VI/II-VI Solid Solutions, Solid Solutions of II-VI and III-V Compounds, Organic Semiconductors.

A corresponding method for spin detection of charged carriers having a spin and forming a flux in a medium, comprising the steps of:

- measuring a first current on a first contact on said medium that has a first spin selectivity ;
- measuring a second current on a second contact on said medium that has a second spin selectivity ;
- comparing said first current and said second current;
- derive the average or statistically relevant spin state of said flux of charge carriers.

In certain embodiment the measurements can start when the spin of said flux of charge carriers is saturated.

In a certain further embodiment the method further comprises the steps of:

- determining a starting time and place, determined as the last moment in time at which said spin of said charge carriers is statistically controlled.

- determining a first current integral in time for a certain duration in time.

- determining a second current integral in time for said certain duration in time.

- comparing said first current integral and said second current integral.

In advantageous embodiments the first current integral and the second current integral are determined over a collection contact dependent period, respectively starting at starting time + delay time 1 and starting time + delay time 2.

Advantageously those delay times delay time 1 and delay time 2 can be the times necessary for the charge carrier flux to bridge the distance between said starting place and said first and said second collection contact respectively added to the time necessary for a charge carrier to diffuse between said first contact and said second contact.

In preferred embodiments this certain duration in time is smaller than the average spin flip time - delay 1 and smaller than the average spin flip time - delay 2.

In another aspect of the present invention a device for performing spin detection is disclosed, comprising :

a. a transport medium, allowing for transport of charge carriers having a spin; [see device embodiments above]

b. means for providing a flux of charge carriers into said medium [see device embodiments above]

c. means for statistically [see device embodiments above] controlling said spin of said charge carriers at a predetermined moment in time;

d. a collection contact

e. a means for measuring the current in said first collection contact

In advantageous embodiments all elements or components present in the detector or detector chain are ultrafast elements.

A corresponding method for spin detection of charged carriers having a spin and forming a flux in a medium, said flux having active and inactive periods [the inactive periods should last longer than N*spin relaxation time, N eg = 1,2,3,4,5,6,7,8,9,10,20,50,100] comprising the steps of:

- determining a starting time and place, determined as the last moment in time at which said spin of said charge carriers is statistically controlled for an active period.
- measuring a current in a first contact on said medium that has a certain spin selectivity over a certain period in time.
- deriving the average or statistically relevant spin state of said period of flux of charge carriers.

This method can further comprise the step of determining a current integral over time of said current over a certain range in time.

Advantageously the range can defined by [starting time + delay time, starting time + delay time + duration], whereby delay time + duration < average spin flip time.

Here the delay time is preferably the time necessary for the charge carrier flux to bridge the distance between said starting place and said collection contact.

In another aspect of the present invention a method for information transfer, is disclosed based on the methods and devices disclosed above comprising the steps of;

- getting information
- encoding information into a bit stream by means of an encoder
- mapping said bit stream onto a block signal having a constant block frequency, said block signal being a periodical flux of charged carriers having a spin, wherein the average spin state of said active period is correlated with the bit content.
- Providing a transport means for said block signal.
- Applying any of the methods according to the present invention already described before for measuring said spin for each of said active periods of said block signal.
- Decoding the spin information into a bitstream

**Short description of the drawings**

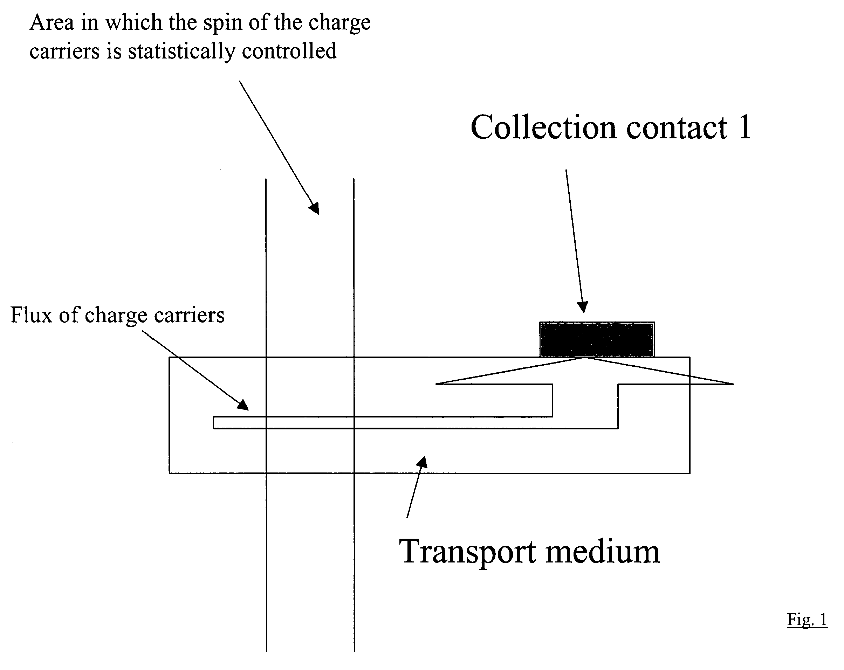

Fig. 1 is an illustration of a device according to an embodiment of the present invention, also related to the time resolved measurement method.

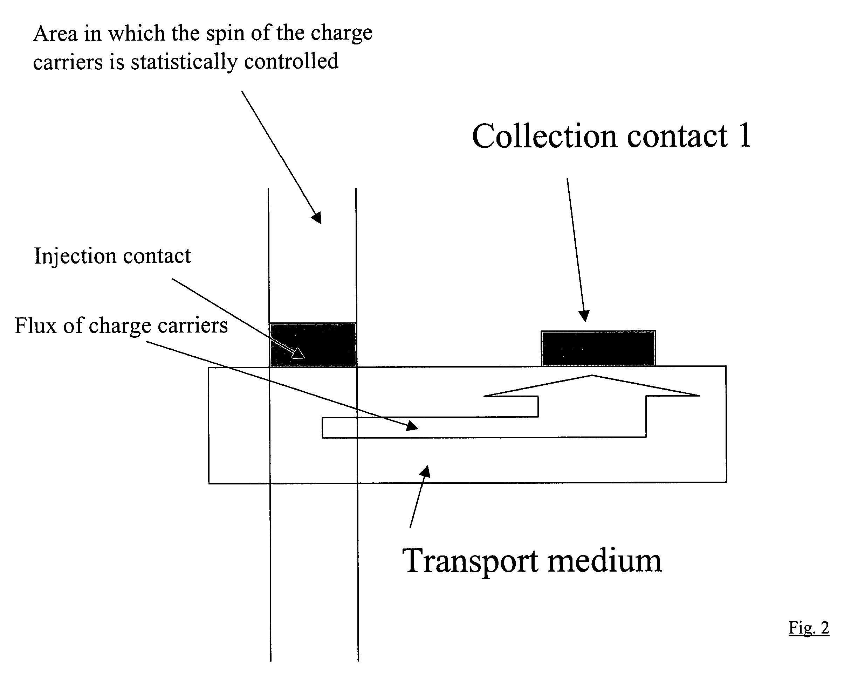

Fig. 2 is a more specific variation of the device depicted in Fig. 1, wherein the means for providing a flux of charge carriers in the medium is an injection contact.

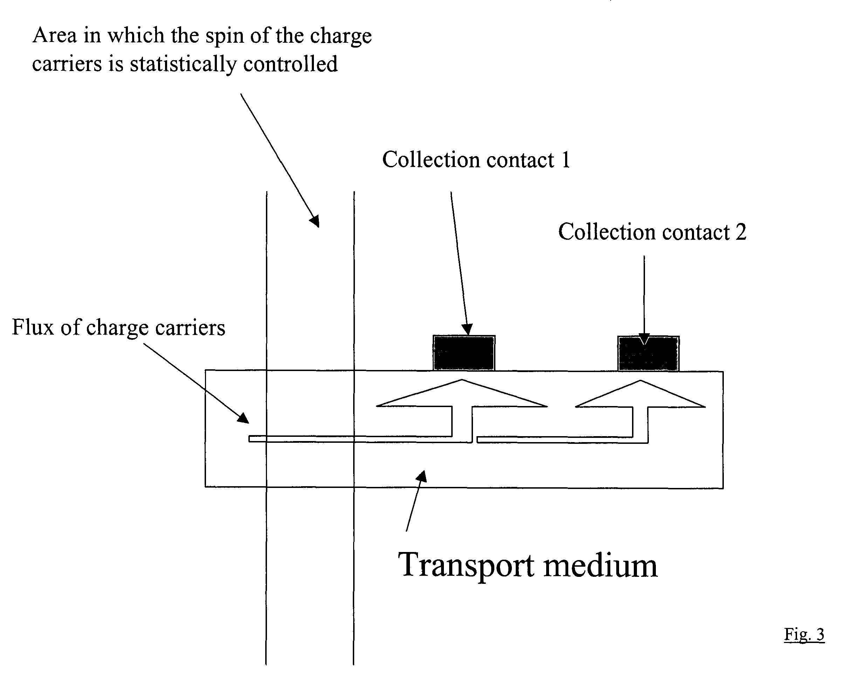

In Fig. 3 a device is illustrated according to an embodiment of the present invention, also related to the differential measurement method, wherein 2 collection electrodes are present.

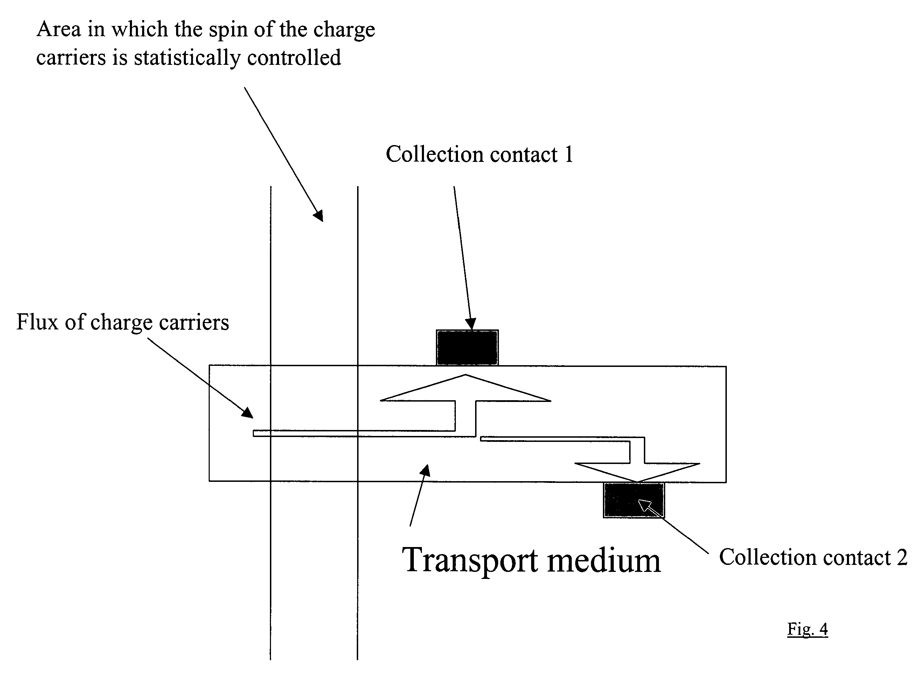

Fig. 4 shows the device of fig. 3 with electrodes on different sides of the transport medium. The interdistance (or times necessary to bridge those distances) between injection electrode or last position of statistical control of the states of the charged carriers in the flux and the collection electrode or electrodes is of importance as described in the text.

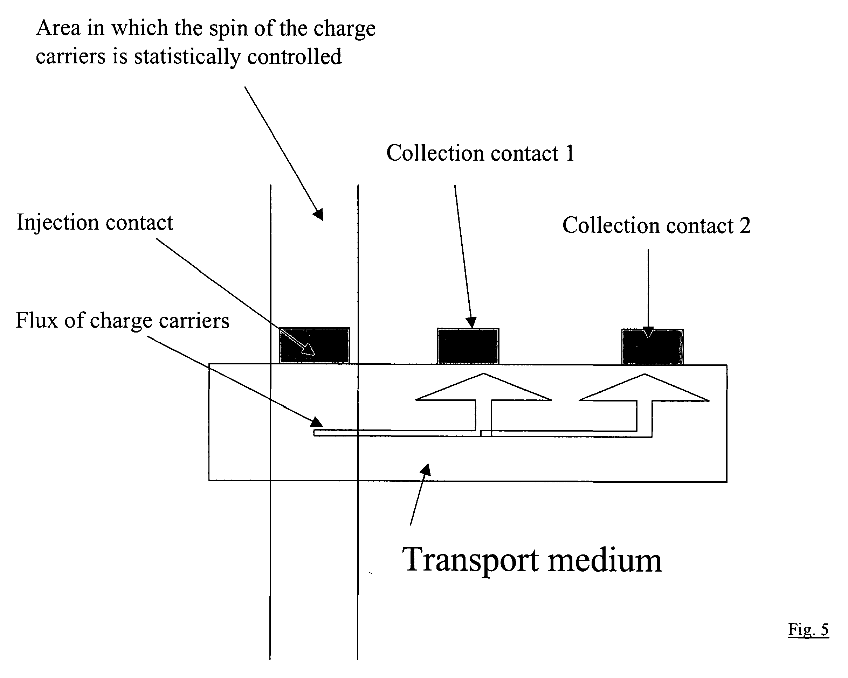

In Fig. 5 the means for providing a flux of charge carriers in the medium is an injection contact.

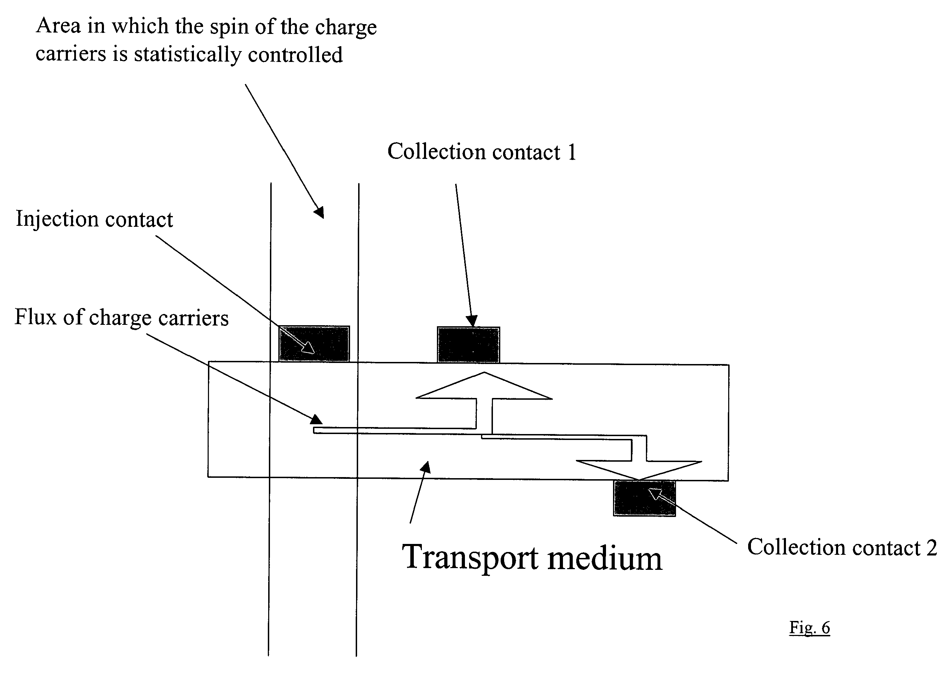

Fig 6 shows the embodiment of fig. 5, wherein one the collection electrodes is situated on a different surface or side of the transport medium.

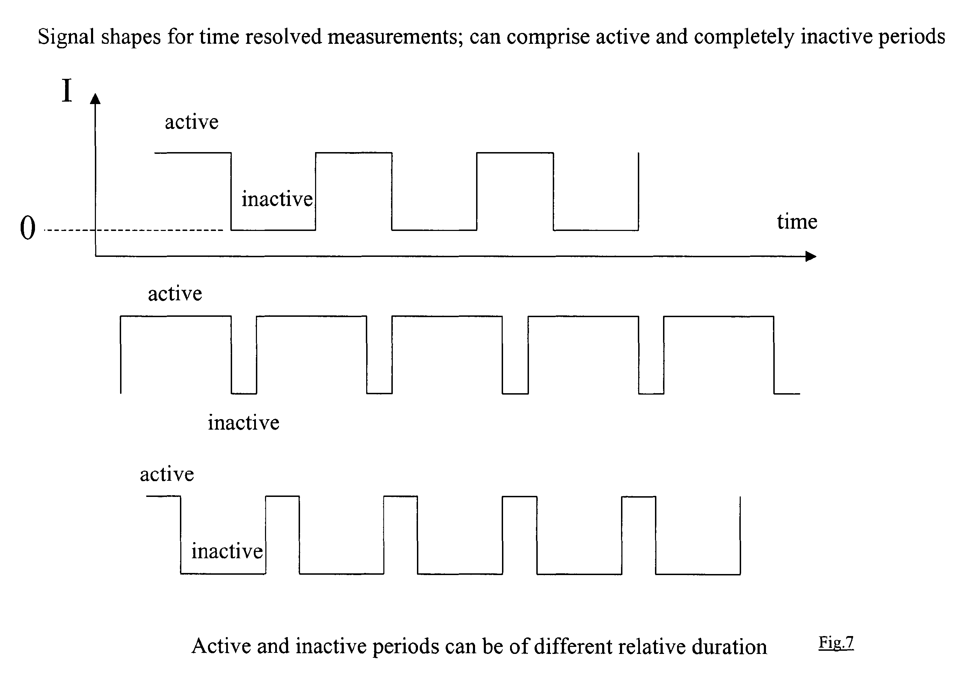

In Fig. 7 some typical signals are shown which can be used for the method and devices relating to the time resolved measurements. The active and inactive periods can have different lengths. One can be longer or shorter than the other.

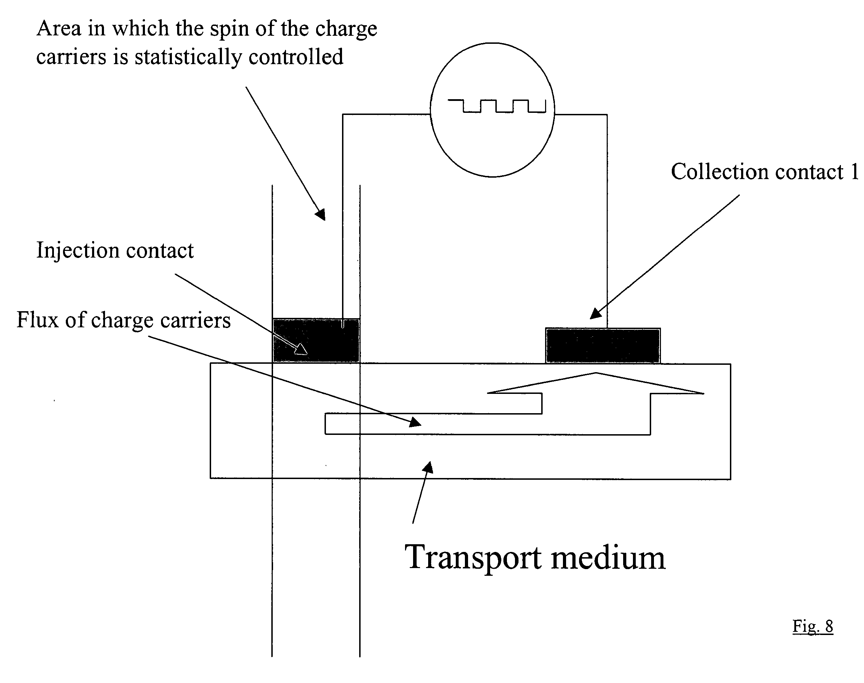

Fig. 8 shows how such a signal can be applied.

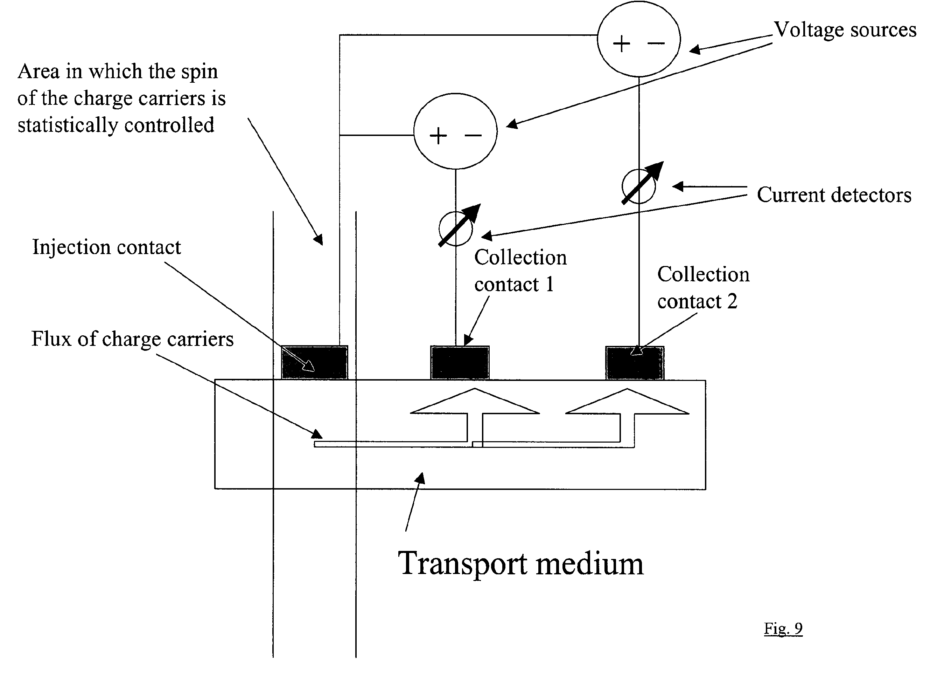

Fig. 9 illustrates a circuitry configuration which can be used for the differential measurement method and corresponding devices.

**Detailed description of the invention**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

An object of certain embodiments of the present invention is a device that consists of two electrical current contacts (used as spin detectors) that have a different spin sensitivity. These contacts are placed on a transport medium (e.g. a semiconductor or a metal), in which a spin-polarized charge carrier density can be created. Some examples include but are not limited to: an electrical contact that can inject spin-polarized carriers in the transport medium; a beam of circularly polarized light that can inject spin-polarized carriers in the transport medium; a magnetic field that polarizes the charge carriers; a spin filter that polarizes the charge carriers; a spintronics device or circuit that transports, manipulates, filters, or performs logic operations on spin polarized carriers that have been injected at one or more other places.

The different spin sensitivity of the two detector contacts may be the result of using two materials with different magnetic properties (e.g. two different magnetic materials, or a magnetic and a non-magnetic material), or using two spin-polarized contacts comprising magnetic materials with magnetizations pointing in different directions (the angle between the two magnetizations can e.g. be 180°, or 90°, or any other angle different from 0°; the two magnetic materials can but need not be identical). The best discrimination will be obtained when the contacts are fully spin-polarized (+100% or -100% polarized, i.e., the current in them is carried by carriers with one type of spin only), and when their polarizations are opposite (i.e., 180° apart). For brevity the following paragraph(s) will be written under this assumption, with the understanding that devices with other configurations will operate with an accordingly reduced discrimination between both spins, but still with the same relative improvement over existing devices with only one detection contact.

The two spin-detector contacts are placed within a small distance from each other, where small is in comparison with the spin diffusion length for the relevant carriers (electrons or holes) inside the transport medium, such that spins that are rejected by a certain contact have a large chance to be absorbed/extracted/removed by the other contact with the opposite spin-sensitivity, compared to the chance that their spin will be flipped and that the charge is extracted by the contact that originally rejected it.

Another object of certain embodiments of the present invention is a method to detect the spin of charge carriers in a medium, using electrical contacts. The method consists of having a medium in which charge carriers are present that can have a spin polarization, and of which one wants to determine this spin polarization.

On the medium two detector contacts are present that have a different spin sensitivity. The distance between these contacts is preferably smaller than N * the spin diffusion length [N = 10, 5, 4, 3, 2, 1, 0.9 to 0.1, 0.01, 0.001], such that there is a significant (theoretically non-zero) probability that a carrier that is rejected by one of the contacts because it has the wrong spin will reach the second contact and attempt to enter there before its spin is flipped, thus before it becomes possible for this carrier to enter the contact that originally rejected it.

Advantageously the distance is smaller than the spin diffusion length.

In certain embodiments the distance between the (optional) injection contact or the latest place for which statistical control of the particle states in the flux of particles is present, and one or both of the collection contacts, is smaller than N' * the spin diffusion length [N = 10, 5, 4, 3, 2, 1, 0.9, 0.8, 0.7, 0.6, 0.5, 0.4, 0.3, 0.2, 0.1, 0.01, 0.001]. N' can be different from N.

The method comprises the steps of measuring a first current on the first contact with a first spin selectivity on the medium, measuring a second current on the second contact with a second spin selectivity on the medium, comparing the first current and the second current, and deriving the average or statistically relevant spin state of the charge carriers present in the medium.

Another object of certain embodiments of the present invention is a device for time-resolved measurements of the spin polarization. This device is similar to the prior art devices that have a single spin detectors, but it has the improvement that the necessary contacts and the measurement circuits allow for fast measurements compared to the spin relaxation time of the charge carriers. This time depends on the type of carrier and the properties of the transport medium. [Zutic, Fabian, and Das Sarma, Rev. Modern Physics 76, 323-410 (2004) — further called ZFD] give a recent review of the known spin relaxation times (sometimes also called spin flip time and denoted $\tau_{sf}$) in many semiconductors. Some values are reproduced below. We refer to the paper as ZFD p. xyz, where xyz gives the actual page number within the ZFD paper.

- electrons in Si, at 4.2 K: $\tau_{sf} \leq 30$ ms in very clean Si/SiGe two-dimensional electron gases, $\tau_{sf}$ is shorter

in samples with higher doping levels or higher levels of impurities, or with structural defects. We note that in bulk n-Si the carriers freeze out at this temperature for doping concentrations below about $1*10^{18}$cm$^{-3}$. The high doping levels required to prevent freeze-out will result in spin relaxation times shorter than the value cited above

- electrons in Si at higher temperatures such as room temperature: $\tau_{sf}$ is shorter than at 4.2 K
- holes in Si: no actual data have been reported, however it is known that $\tau_{sf}$ is smaller than the spin relaxation time for electrons in Si at the same temperature
- electrons in bulk GaAs [ZFD p. 363]: largest reported values are 130-180 ns at 4.2 K for n-type doping concentrations of $3*10^{15}$ to $2*10^{16}$ cm$^{-3}$. The spin relaxation time drops quickly with increasing doping concentration to 0.2 ns = 200 ps at $1*10^{18}$ cm$^{-3}$.
- electrons in GaAs at higher temperatures [ZFD p. 364]: for an n-type doping concentration of $1*10^{16}$ cm$^{-3}$: $\tau_{sf}$ = 130 ns at 4.2 K, 10 ns at 50 K, 1.2 ns at 100 K, 600 ps at 150 K.

All other examples of this paper can be used to illustrate the functioning of the methods and devices according to embodiments of the present invention. Therefore this paper is incorporated by reference.

These times set the lower limit on the speed that separates "fast" from "slow" spin detectors. A spin detector consists of different elements or component, each with its own characteristics. To build a "fast" spin detector, all elements need to be fast. For instance an embodiment of the detector according to the present invention has the following specification (typical values are given in the following): wire bonds 6 GHz (flip-chip connections would be: 10 GHz), feed throughs and cabling in the cryostate for low T measurements: 5-6 GHz, signal and delay generators: 10 GHz, detector (oscilloscope): 20 GHz, coplanar wave guides: 40 GHz. The lowest frequency of the whole chain determines the performance of the system. At low temperatures: 5 GHz or 200 ps, at room temperature 10 GHz or 100 ps]. Current microprocessors and integrated circuits already run at these speeds.

An ultra fast detector needs ultra fast contacts. For embodiment of the present invention related to the time-resolved measurement and device therefore, such an ultra fast contact - and moreover ultra fast chain of other elements or components needs to be present.

In other embodiment one or more of such ultrafast contacts can be advantageous.

One of the elements in such a chain of elements/components building a spin detector is the injection means, which needs to be ultrafast for embodiment of the present invention related to the time-resolved measurement and device therefore.

- electrical injection using a fast contact, and distance between injection contact and detection contact smaller than spin flip length.
- optical injection using fast circularly polarized optical beam.
- any circuit that performs a fast calculation /manipulation that results in spin-polarized carriers.

In other embodiment an ultrafast injection contacts can also be advantageous.

A further object of certain embodiments of the present invention is a method for electrical spin detection using one or more ultrafast contacts. The description below is given for one ultrafast contact. It can also be used with two or more ultrafast contacts, where it can e.g. combine the improvements of the differential measurement method of certain embodiments of this invention with the benefits of the ultrafast measurements. The implementation of this kind of combination is straightforward and is therefore not detailed here.

The method for electrical spin detection using one or more ultrafast contacts comprises the following steps ;

- optionally prepare the medium in an "empty" state or steady-state state, where empty means that the concentration of carriers of either type of spin is small compared to the amount of carriers that will be provided in the following step. In other words, even when all the carriers that remain at the end of this step would be collected by one of the contacts in the third step, then the corresponding current would be significantly smaller than the largest of the current resulting from the carriers injected in the second step
- prepare / inject quickly
- detect quickly [= within spin-relaxation time of the start of injection]
- stop injecting
- optionally empty the medium such that a new measurement can be performed, e.g.

   ● by waiting several times the spin relaxation time (such that all carriers can be absorbed by the single contact, independent of their initial spin)

   ● by having a second contact with opposite spin polarization that removes the type of spins that are not removed by the first contact. If this contact also has ultrafast connections and if its current is compared with that of the first contact, then this is an ultrafast differential method

   ● by having a second contact that removes both types of spin. If this contact also has ultrafast connections and if its current is compared with that of the first contact, then this is an ultrafast differential method

● letting the carriers recombine with carriers with an opposite charge (electrons with holes, or holes with electrons). These carriers with an opposite charge can e.g. be the result of doping, or of a contact that injects these carriers, or be generated at the same time as the original barriers when an ultrafast light beam is used to excite electron-hole pair.

**Claims**

1. A method for spin detection of charged carriers having a spin and forming a flux in a transport medium, comprising the steps of:

   - Providing a flow of charged charge carriers from a starting point at a specific starting time to a first collection contact through said transport medium, wherein said charge carriers travel from said starting point to said first collection contact in a first travel time period,
   - measuring a first current of charge carriers during a measuring time period in said first collection contact in electrical contact with said transport medium, said first collection contact having a first spin selectivity,
   - deriving the spin state of said flux of charge carriers during said period, and
   - removing the charge carriers having a spin state for which said first collection contact is not selective.

2. The method according to claim 1 wherein the sum of the measuring time period and the first travel time period is smaller than the average spin flip time and wherein the step of removing the charge carriers comprises providing a waiting time in which no flux is present in the transport medium, wherein said waiting time is higher than the average spin flip time.

3. The method according to claim 1 or 2, further comprising the step of determining a current integral over time of the current of charge carriers in the first collection contact over the measuring time period.

4. The method of claim 1, wherein the step of removing the charge carriers comprises the step of measuring a second current in a second collection contact in electrical contact with said transport medium, said second collection contact having a second spin selectivity different from said first spin selectivity, wherein said charge carriers travel from said starting point to said second collection contact in a second travel time period

5. The method of claim 4, further comprising the step of comparing said first current and said second current.

6. The method of claim 5 wherein the measuring step is started when the spin of said flux of charge carriers is in a steady state.

7. The method according to claim 5 or 6, further comprising the steps of:

   - determining a first current integral in time for the first current over a first time period,
   - determining a second current integral in time for the second current over a second time period,
   - comparing said first current integral and said second current integral.

8. The method as in claim 7, wherein the first time period and the second time period start respectively after the sum of starting time, first travel time and the sum of starting time and second travel time.

9. The method as in any of the claims 7 or 8, wherein the first time period and second time period are respectively smaller than the average spin flip time minus the first travel time and smaller than the average spin flip time minus the second travel time.

10. A device for performing spin detection, comprising :

    • a transport medium, allowing for transport of charge carriers having a spin;
    • a charge carrier source for providing a flux of charge carriers into said transport medium
    • means for statistically controlling said spin of said charge carriers at a predetermined moment in time;
    • a first collection contact in electrical contact with said transport medium, said first collection contact having a first spin-selectivity;
    • a first current measuring device arranged to measure the current in said first collection contact;
    • a second collection contact in electrical contact with said transport medium, said second collection contact having a second spin-selectivity;
    • a second current measuring device arranged to measure the current in said second collection contact;

    wherein said first selectivity is different from said second selectivity and whereby said flux of charge carriers is guided towards said first and said second collection contacts from said predetermined moment in time.

11. The device as in claim 10, wherein the first collection contact or second collection contact is selected from the group consisting of a magnetic metal; a ferromagnetic metal; a ferrimagnetic metal; a tunnel injector selected from the group consisting of a magnetic metal with a tunnel barrier, a non-magnetic metal with a magnetic tunnel barrier, a magnetic metal with a magnetic tunnel barrier, a ferromagnetic metal with a tunnel barrier, a non-ferromagnetic metal with a magnetic tunnel barrier, a ferromagnetic metal with a magnetic tunnel barrier, a ferrimagnetic metal with a tunnel barrier, a non-ferrimagnetic metal with a magnetic tunnel barrier, a ferrimagnetic metal with a magnetic tunnel barrier; a half-metallic ferromagnet, a half-metallic ferrimagnet, a half-metallic antiferromagnet, a magnetic semiconductor, or a ferromagnetic semiconductor.

12. The device according to any of the claims 10 or 11, wherein the charge carrier source comprises an electrical injection contact.

13. The device according to claim 12, wherein the injection contact has a predetermined magnetic polarisation and the injection contact functions as said means for statistically controlling said spin of said charge carriers.

14. The device as in any of the preceding claims 10 to 13, wherein the means for statistically controlling the spin of the charge carriers is a electromagnetic field, localised at a specific position along the path of the charge carriers in the transport medium, an optical injection means, the result of a spintronic action, manipulation, operation, or calculation, or the result of a quantum computing or quantum cryptography operation.

15. The device as in any of the preceding claims 10 to 14, wherein the charge carrier source is arranged to provide a potential difference between said injection contact and said first and said second collection contacts.

16. The device as in any of the preceding claims 10 to 15, wherein the first collection contact and said second collection contact have a different spin polarisation.

17. The device as in any of the preceding claims 10 to 16, wherein the first collection contact and the second collection contact have different magnetization directions, forming an angle different from 0.

18. The device as in any of the preceding claims 10 to 17, wherein the injection contact and the first and the second collection contact are positioned on the same side or on different sides of said transport medium.

19. The device as in any of the preceding claims 10 to 18, wherein the transport medium comprises a semiconductor material or a metal.

20. A device for performing spin detection, comprising :

    • a transport medium, allowing for transport of charge carriers having a spin;
    • means for providing a flux of charge carriers into said medium;
    • means for statistically controlling said spin of said charge carriers at a predetermined moment in time;
    • a first collection contact
    • a means for measuring the current in said first collection contact.

21. The device according to claim 20 wherein all elements or components present in the detector or detector chain are ultrafast elements.

22. A method for information transfer, comprising the steps of;

    - Providing information to transfer,
    - encoding said information into a bit stream with an encoder,
    - mapping said bit stream onto a block signal having a constant block frequency, said block signal being a periodical flux of charged carriers having a spin, wherein the average spin state of said active period is correlated with the bit content,
    - Providing a transport means for said block signal.
    - Applying any of the methods according to any of the claims 1 to 9 for measuring said spin for each of said active periods of said block signal, and
    - Decoding the spin information into a bitstream

Area in which the spin of the charge
carriers is statistically controlled

Collection contact 1

Flux of charge carriers

Transport medium

Fig. 1

EP 1 715 356 A1

Area in which the spin of the charge
carriers is statistically controlled

Collection contact 1

Injection contact

Flux of charge carriers

Transport medium

Fig. 2

EP 1 715 356 A1

Area in which the spin of the charge
carriers is statistically controlled

Collection contact 1

Collection contact 2

Flux of charge carriers

Transport medium

EP 1 715 356 A1

Fig. 3

Area in which the spin of the charge
carriers is statistically controlled

Collection contact 1

Flux of charge carriers

Transport medium

Collection contact 2

Fig. 4

EP 1 715 356 A1

Area in which the spin of the charge
carriers is statistically controlled

Collection contact 1

Injection contact

Collection contact 2

Flux of charge carriers

Transport medium

EP 1 715 356 A1

Fig. 5

Area in which the spin of the charge
carriers is statistically controlled

Collection contact 1

Injection contact

Flux of charge carriers

Transport medium

Collection contact 2

EP 1 715 356 A1

Fig. 6

Signal shapes for time resolved measurements; can comprise active and completely inactive periods

Active and inactive periods can be of different relative duration

Fig.7

EP 1 715 356 A1

Area in which the spin of the charge
carriers is statistically controlled

Collection contact 1

Injection contact

Flux of charge carriers

Transport medium

Fig. 8

Fig. 9

**European Patent Office**

**EUROPEAN SEARCH REPORT**

Application Number

EP 05 44 7084

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JOHNSON M: "Spin injection in metals: The bipolar spin transistor" JOURNAL OF MAGNETISM AND MAGNETIC MATERIALS, ELSEVIER SCIENCE PUBLISHERS, AMSTERDAM, NL, vol. 156, no. 1-3, April 1996 (1996-04), pages 321-324, XP004078788 ISSN: 0304-8853 * page 322, left-hand column, line 4 - right-hand column, line 13; figure 1 * | 20 | G01R33/06 H01L29/66 |
| A | | 1,10-12, 15,16, 18,19 | |
| A | JOHNSON M: "SPIN INJECTION IN METAL FILMS: THE BIPOLAR SPIN TRANSISTOR" MATERIALS SCIENCE AND ENGINEERING B, ELSEVIER SEQUOIA, LAUSANNE, CH, vol. 31, no. 1/2, April 1995 (1995-04), pages 199-205, XP002036340 ISSN: 0921-5107 * page 200, right-hand column, last paragraph - page 201, left-hand column, paragraph 2; figure 2b * | 1,4-7 | |
| A | JOHNSON M: "THE ALL-METAL SPIN TRANSISTOR" IEEE SPECTRUM, IEEE INC. NEW YORK, US, vol. 31, no. 5, 1 May 1994 (1994-05-01), pages 47-51, XP000456263 ISSN: 0018-9235 | | TECHNICAL FIELDS SEARCHED (IPC) G01R H01L |
| A | US 5 514 899 A (LAU ET AL) 7 May 1996 (1996-05-07) | | |

The present search report has been drawn up for all claims

| Place of search | Date of completion of the search | Examiner |
|---|---|---|
| The Hague | 21 November 2005 | Swartjes, H |

EPO FORM 1503 03.82 (P04C01)

## ANNEX TO THE EUROPEAN SEARCH REPORT
## ON EUROPEAN PATENT APPLICATION NO.

EP 05 44 7084

This annex lists the patent family members relating to the patent documents cited in  the above-mentioned European search report.
The members are as contained in the European Patent Office EDP file on
The European Patent Office is in no way  liable for these particulars which are merely  given for the purpose of information.

21-11-2005

| Patent document cited in search report | Publication date | Patent family member(s) | Publication date |
|---|---|---|---|
| US 5514899 A | 07-05-1996 | NONE | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ZUTIC ; FABIAN ; DAS SARMA.** *Rev. Modern Physics,* 2004, vol. 76, 323-410